# EUROPÄISCHE PATENTSCHRIFT

(11) **EP 3 312 959 B1**
(45) Veröffentlichungstag und Bekanntmachung des Hinweises auf die Patenterteilung: **19.06.2019**
(21) Anmeldenummer: 17197445.4
(22) Anmeldetag: 20.10.2017
(51) Int. Cl.: H02H 1/00, H02H 1/04, H02H 3/06, H02H 3/093, H02H 3/24, H02H 3/247, H02H 11/00

(54) **ENERGIEVERSORGUNGSEINHEIT ZUR BEREITSTELLUNG ZUMINDEST EINES SCHALTBAREN ENERGIEAUSGANGS**
ENERGY SUPPLY UNIT FOR PROVIDING AT LEAST ONE SWITCHABLE ENERGY OUTPUT
UNITÉ D'ALIMENTATION ÉLECTRIQUE PERMETTANT DE FOURNIR AU MOINS UNE SORTIE D'ÉNERGIE COMMUTABLE

(30) Priorität: 21.10.2016 DE 102016120099
(43) Veröffentlichungstag der Anmeldung: 25.04.2018
(73) Patentinhaber: PHOENIX CONTACT GmbH & Co. KG, 32825 Blomberg (DE)
(72) Erfinder: Fomenko, Alexander, 33605 Bielefeld (DE); Wölk, Gerhard, 32816 Schieder-Schwalenberg (DE)
(74) Vertreter: RCD Patent Giesen, Schmelcher & Griebel Patentwanwälte PartG mbB

(56) Entgegenhaltungen:
- EP-A1- 1 185 149
- EP-A2- 0 968 871
- CN-U- 202 930 903
- DE-A1- 19 705 776

## Beschreibung

Die Erfindung betrifft eine Energieversorgungseinheit zur Bereitstellung zumindest eines schaltbaren Energieausgangs.

Aus dem Stand der Technik sind zahlreiche Energieversorgungseinheiten bekannt.

Aus der DE 197 05 770 A1 ist eine Energieversorgungseinheit zur Bereitstellung zumindest eines schaltbaren Energieausgangs aufweisend zumindest einen Energieeingang, zumindest eine Spannungsmesseinrichtung, die die Spannung an dem zumindest einen Energieeingang überwacht bekannt. Diese Energieversorgungseinheit ist jedoch auf eine bestimmte Last bezogen ausgelegt und daher nicht in der Lage bei unterschiedlichen Lasten einen echten Kurzschluss von einem virtuellen Kurzschluss zu unterscheiden.

Dabei erweist es sich als großes Problem echte Kurzschlüsse von virtuellen Kurzschlüssen zu unterscheiden. Virtuelle Kurzschlüsse entstehen durch kapazitive Lasten, die sich insbesondere beim Einschalten wie ein Kurzschluss verhalten. D.h. bis die kapazitive Last entsprechend geladen ist fließen teils erhebliche Ströme.

Daher wurden in der Vergangenheit immer wieder Versuche unternommen, diese virtuellen Kurzschlüsse zu erkennen.

Beispielsweise ist aus der DE 10 2012 103 551 A1 eine elektronische Sicherungsvorrichtung bekannt, die einen Controller-gesteuerten Schalter in Abhängigkeit von einem (ausgangsseitigem) Überstrom ausschaltet und in Abhängigkeit der Spannungsänderung am Ausgang wieder einschaltet. Eine hierzu ähnliche Vorrichtung ist aus der DE 10 2013 105 942 A1 bekannt.

Jedoch ist der Aufbau dieser Vorrichtungen kompliziert. Insbesondere erfordern sie eine (ausgangsseitige) Strommessung anhand derer entschieden wird, ob ein gefährlicher Zustand eines echten Kurzschlusses vorliegt.

Es kann zudem sein, dass das Versorgungsnetz für eine solche Erkennung den nötigen Strom, oder den Kurzschlussstrom nicht liefern kann. Solche Zustände können z.B. dadurch eintreten, dass das Versorgungsnetz bereits stark ausgelastet ist, oder aber fehlerhaft (z.B. nicht leistungsfähig genug) ausgelegt ist.

Zudem kann bei schwachen Netzteilen es auch sein, dass die Spannung bei einem Kurzschluss sehr stark zusammenbricht. Dies kann dazu führen, dass z.B. die Boardversorgung für den Controller (zur Kurzschlusserkennung und/oder Schalteransteuerung) ebenfalls zusammenbricht und der Controller bei einem Kurzschluss nicht reagieren kann.

Der Erfindung liegt die Aufgabe zu Grunde, eine verbesserte und kostengünstige Energieversorgungseinheit zur Bereitstellung zumindest eines schaltbaren Energieausgangs zu schaffen, die einen oder mehrere Nachteile aus dem Stand der Technik vermeidet.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Nachfolgend wird die Erfindung unter Bezugnahme auf die anliegende Zeichnung anhand bevorzugter Ausführungsformen näher erläutert.

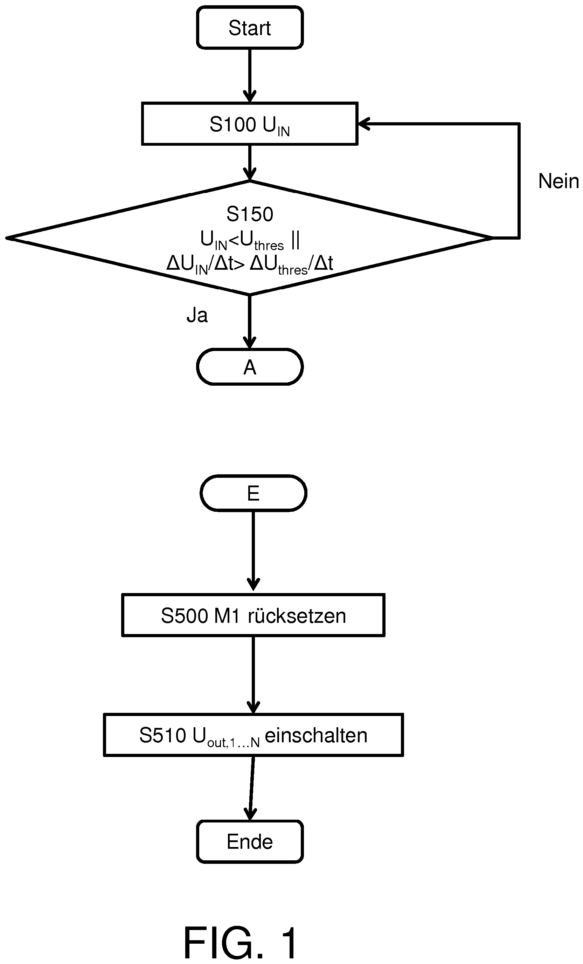

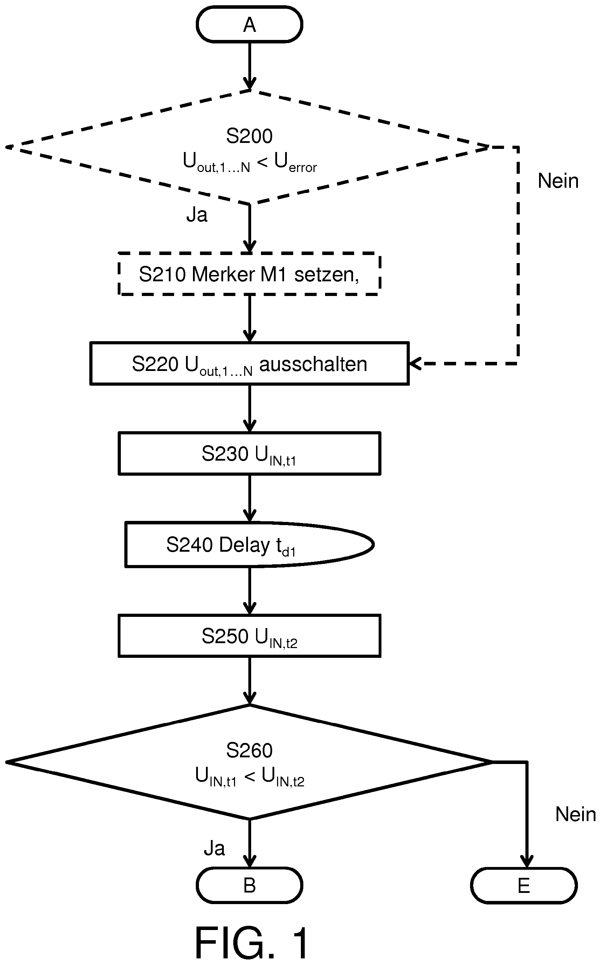

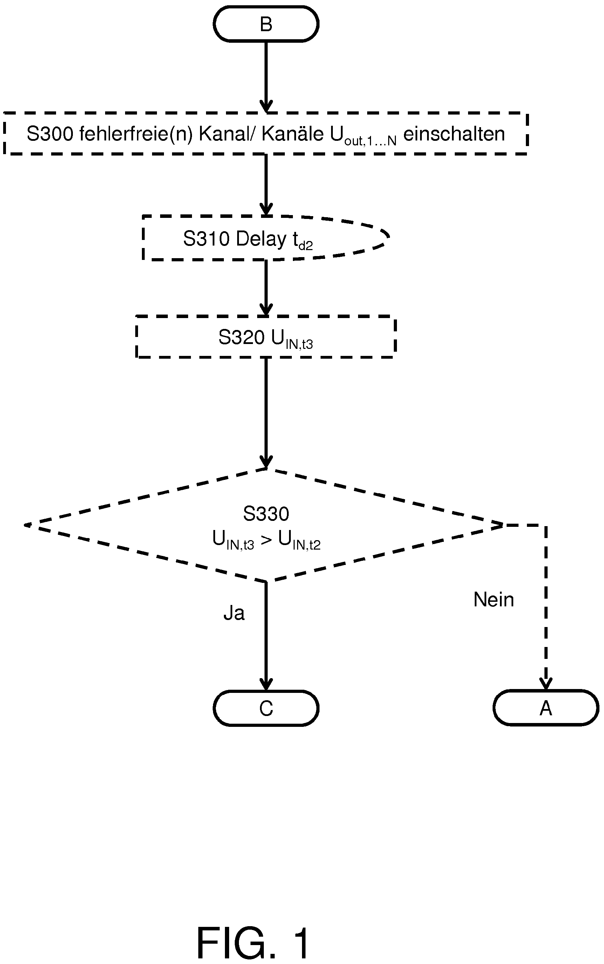

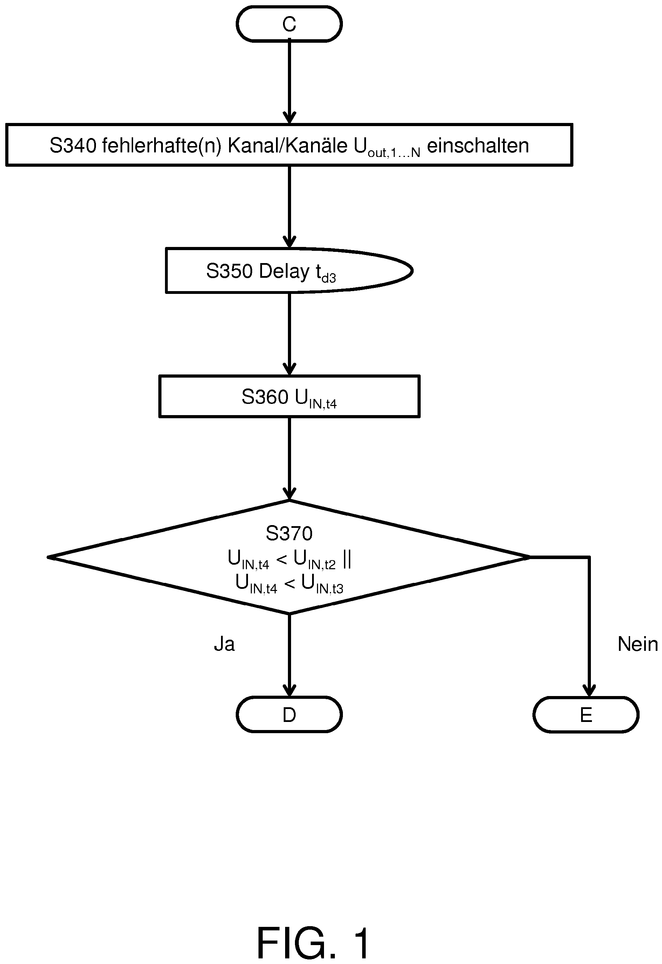

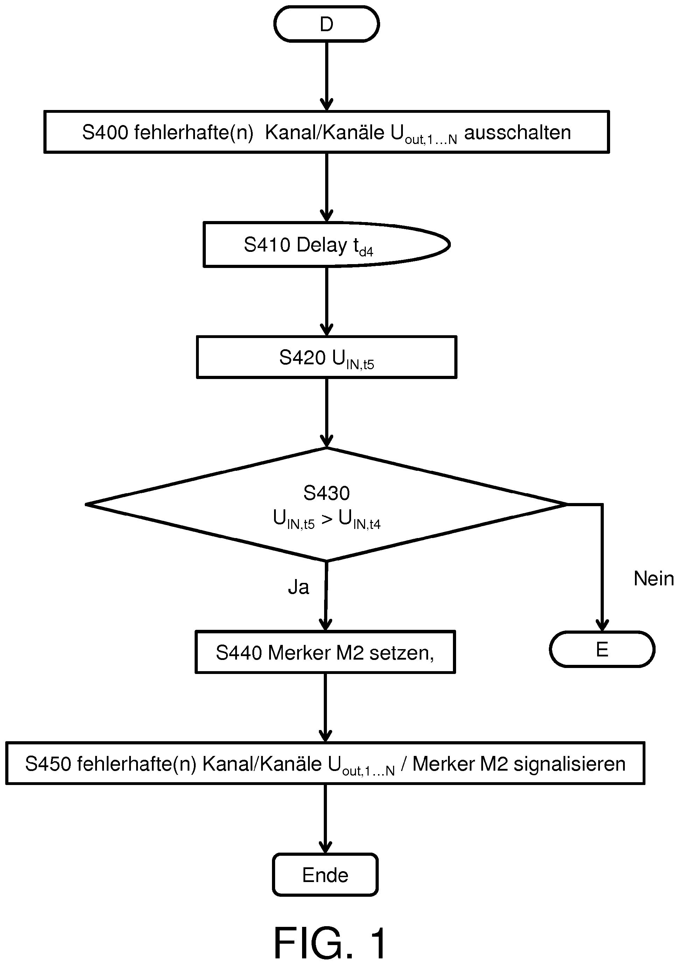

Es zeigt
Fig. 1 ein Flussdiagramms von Ausführungsformen der Erfindung.

Nachfolgend wird die Erfindung eingehender unter Bezugnahme auf die Figur dargestellt werden. Dabei ist anzumerken, dass unterschiedliche Aspekte beschreiben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Auf Grund der Größe des Flussdiagramms, das verschieden Aspekte von Ausführungsformen zeigt, wurde dieses über mehrere Seiten verteilt, wobei die Schnittstellen klar durch A, B, C, D und E gekennzeichnet sind.

Soweit in dem Flussdiagramm einzelne Schritte z.B. in gestrichelter Darstellung angegeben sind, sind diese Schritte in Bezug auf Ausführungsformen mit zwei oder mehr Energieausgängen Uₒᵤₜ₁, Uₒᵤₜ₂, ..., U_{outN} zu verstehen. Der Fall eines einzelnen Energieausgangs entspricht N=1.

Das nachfolgend beschriebene Verfahren bezieht sich auf das intelligente Erkennen und sicheres Abschalten der gefährlichen Zustände z. B. Kurzschlüsse, oder unzulässig hohe Ströme in den Versorgungsnetzen (insbesondere DC-Versorgungsnetzen) mittels eines Schutzschalters.

In dem Erfindungsverfahren wird das Problem gelöst in dem bei einem zu starken Einbruch der Eingangsspannung eine Sonderauswertung der Netzzustände gestartet wird. Dabei ist zu keinem Zeitpunkt eine Strommessung erforderlich.

Eine erfindungsgemäße Energieversorgungseinheit ist geeignet zur Bereitstellung zumindest eines schaltbaren Energieausgangs Uₒᵤₜ₁, Uₒᵤₜ₂, ..., U_{outN}, wobei N eine natürliche Zahl ist.

Die erfindungsgemäße Energieversorgungseinheit weist zumindest einen Energieeingang U_{IN} und zumindest eine Spannungsmesseinrichtung auf, die die Spannung an dem zumindest einen Energieeingang U_{IN} überwacht.

Die Eingangsspannung U_{IN} (bzw. die Änderung der Eingangsspannung in einem vorbestimmten Zeitraum) wird in einem ersten Schritt S100 gemessen.

Wenn nun die Eingangsspannung U_{IN} unter einen bestimmten Schwellwert Uₜₕᵣₑₛ fällt oder wenn die Änderung der Eingangsspannung U_{IN} pro Zeit über einen bestimmten Schwellwert ΔUₜₕᵣₑₛ/Δt steigt wird in Schritt S150 entschieden, dass einen weitere Untersuchung notwendig ist. Es sei angemerkt, dass der Schwellwert Uₜₕᵣₑₛ und der Schwellwert ΔUₜₕᵣₑₛ/Δt unabhängig voneinander gewählt sein können.

Beispielsweise wird / werden in einem Schritt S220 der Energieausgang / die Energieausgänge Uₒᵤₜ₁, Uₒᵤₜ₂, ..., U_{outN} ausgeschaltet und anschließend wird die Eingangsspannung U_{IN,t1} zu einem ersten Zeitpunkt t₁ in einem Schritt S230 gemessen, wobei nach einer ersten vorbestimmten Zeit t_{d1} - z.B. 2.5 ms - (Delayschritt S240) die Eingangsspannung U_{IN,t2} zu einem zweiten Zeitpunkt t₂ in einem Schritt S250 erneut gemessen wird. Wenn die Eingangsspannung U_{IN,t2} zum zweiten Zeitpunkt t₂ höher ist als die Eingangsspannung U_{IN,t1} zum ersten Zeitpunkt t₁, wird in Schritt S260 angenommen, dass ein Kurzschluss an zumindest einem Energieausgang vorliegt. Steigt die Eingangsspannung nicht an, so wurde der Spannungseinbruch nicht durch einen Kurzschluss verursacht und die Erkennung wird verlassen. Der Delayschritt S240 sollte daher ausreichend bemessen sein, um ein Erholen der Eingangsspannung unter regulären Bedingungen zu ermöglichen.

In einer weiteren Ausgestaltung der Erfindung wird / werden nachfolgend zur Annahme in Schritt S260, dass ein Kurzschluss an zumindest einem Energieausgang vorliegt, der als fehlerhaft angenommene Energieausgang / die als fehlerhaft angenommenen Energieausgänge Uₒᵤₜ₁, Uₒᵤₜ₂, ..., U_{outN} in Schritt S340 eingeschaltet und anschließend wird nach einer dritten vorbestimmten Zeit t_{d3} z.B. 0.5 ms - (Delayschritt S350) die Eingangsspannung U_{IN,t4} zu einem vierten Zeitpunkt t₄ in einem Schritt S360 erneut gemessen, wobei, wenn die Eingangsspannung zum vierten Zeitpunkt t₄ niedriger ist als die zuvor (t₂ ;t₃) gemessene Eingangsspannung, in Schritt S370 erhärtet angenommen wird, dass ein Kurzschluss an zumindest dem als fehlerhaft angenommene Energieausgang / den als fehlerhaft angenommenen Energieausgängen vorliegt. An dieser Stelle sei darauf hin gewiesen, dass die zuvor gemessene Eingangsspannung in aller Regel eine unmittelbar zuvor gemessene Eingangsspannung ist. Nachfolgend kann sich z.B. für den Fall mehrerer Energieausgänge Uₒᵤₜ₁, Uₒᵤₜ₂, ..., U_{outN} ergeben, dass z.B. eine weitere Messung zwischengeschoben werden kann. Ist die Eingangsspannung gleich geblieben oder gestiegen, wird die Erkennung verlassen, da die Ursache nicht in einem Kurzschluss am Ausgang liegt. Ist die Eingangsspannung gesunken, so wird der fehlerhafte angenommene Energieausgang bzw. die der fehlerhaft angenommenen Energieausgänge wieder ausgeschaltet.

In einer weiteren Ausgestaltung der Erfindung wird / werden nachfolgend zur erhärteten Annahme in Schritt S370, dass ein Kurzschluss an zumindest dem als fehlerhaft angenommene Energieausgang / den als fehlerhaft angenommenen Energieausgängen vorliegt, der als fehlerhaft angenommene Energieausgang / die als fehlerhaft angenommenen Energieausgängen in Schritt S400 ausgeschaltet, und anschließend nach einer vierten vorbestimmten Zeit t_{d4} - z.B. 0.5 ms - (Delayschritt S410) die Eingangsspannung U_{IN,t5} zu einem fünften Zeitpunkt t₅ in einem Schritt S420 erneut gemessen wird, wobei, wenn die Eingangsspannung zum fünften Zeitpunkt t₅ höher ist als die zum vierten Zeitpunkt t₄ gemessene Eingangsspannung U_{IN,t4}, in Schritt S430 entschieden wird, dass ein Kurzschluss an zumindest dem als fehlerhaft angenommene Energieausgang / den als fehlerhaft angenommenen Energieausgängen vorliegt. Ist die Eingangsspannung gleich geblieben oder gesunken, wird die Erkennung verlassen, da die Ursache nicht in einem Kurzschluss am Ausgang liegt. Ist die Eingangsspannung gestiegen, so wird der als fehlerhaft angenommene Energieausgang / die als fehlerhaft angenommenen Energieausgänge als Kurzschluss abgeschaltet und signalisiert.

In einer weiteren Ausgestaltung der Erfindung wird ein als fehlerhaft erkannter Energieausgang in Schritt S450 lokal oder mittels einer Fernmeldung signalisiert. Hierzu kann eine geeignete lokale Anzeige, z.B. mittels Leuchtanzeigen oder ElectronicPaper-Displays oder dergleichen, und/oder eine akustische Anzeige, z.B. mittels eines Summers oder dergleichen, oder eine Fernmeldung z.B. mittels eines Fernmeldekontaktes als Schließer oder Öffner und/oder eine Datenschnittstelle vorgesehen sein.

In einer weiteren Ausgestaltung der Erfindung, die nachfolgend beschrieben wird, stellt die Energieversorgungseinheit eine Mehrzahl von Energieausgängen zur Verfügung.

In diesem Fall kann es vorteilhaft sein, einen mutmaßlichen fehlerhaften Energieausgang zu bestimmen. Prinzipiell möglich ist es einen fehlerhaften Energieausgang / fehlerhafte Energieausgänge durch eine Einzelabfrage in sequentieller oder randomisierter Reihenfolge zu ermitteln. Allerdings kann durch eine Beobachtung der jeweiligen Ausgangsspannungen auch ein Rückschluss über ein mutmaßlich fehlerhafte Energieausgang/ mehrere mutmaßlich fehlerhafte Energieausgänge gewonnen werden. Hierzu wird zweckmäßigerweise nachfolgend zur Erkennung in schritt S150, dass die Eingangsspannung unter einen bestimmten Schwellwert Uₜₕᵣₑₛ fällt oder wenn die Änderung der Eingangsspannung U_{IN} pro Zeit über einen bestimmten Schwellwert ΔUₜₕᵣₑₛ/Δt steigt, ein mutmaßlich fehlerhafter Energieausgang zumindest an Hand der jeweiligen Ausgangsspannung in Schritt S200 bestimmt.

Hierzu können verschiedenste Techniken angewandt werden. Z.B. kann der Absolutwert der jeweiligen Ausgangsspannung betrachtet werden, so dass z.B. der niedrigste Absolutwert eines Energieausgangs als ein Indiz gewertet werden kann. Alternativ oder zusätzlich kann auch eine die jeweils gemessene Ausgangsspannung eines Energieausgangs in Bezug zu einer vorgesehenen Ausgangsspannung in Bezug gesetzt werden und als (weiteres) Indiz dienen. Ebenso kann auch die Eingangsspannung mitberücksichtigt werden, sodass z.B. die Eingangsspannung U_{IN} vermindert um eine gemessen Ausgangsspannung in Bezug zu einem bestimmten Schwellwert U_{ERR} gesetzt wird.

Hieraus kann sodann ein mutmaßlicher fehlerhafter Energieausgang oder mutmaßlich fehlerhafte Energieausgänge bestimmt werden, die z.B. in einem Schritt S210 in einem Merker M1, z.B. in einem ein Speicherarray, vermerkt werden. Vorteilhafterweise sollte das Speicherarray zumindest N binäre Speicherzellen aufweisen, sodass jeder der N Energieausgänge als fehlerhaft / fehlerfrei abgespeichert werden kann.

In einer weiteren Ausgestaltung der Erfindung, die nachfolgend beschrieben wird, stellt die Energieversorgungseinheit wiederum eine Mehrzahl von Energieausgängen zur Verfügung.

Nachfolgend zur Annahme in Schritt S260, dass ein Kurzschluss an zumindest einem Energieausgang vorliegt, wird der als fehlerfrei angenommen Energieausgang / die als fehlerfrei angenommenen Energieausgänge in Schritt S300 eingeschaltet werden und anschließend nach einer zweiten vorbestimmten Zeit t_{d2} - z.B. 0.5 ms - (Delayschritt S310) die Eingangsspannung U_{IN,t3} zu einem dritten Zeitpunkt t₃ in Schritt S320 erneut gemessen, wobei, wenn die Eingangsspannung zum dritten Zeitpunkt höher ist als die zum zweiten Zeitpunkt t₂ gemessene Eingangsspannung U_{IN,t2}, verstärkt in Schritt S330 angenommen wird, dass ein Kurzschluss an zumindest dem als fehlerhaft angenommene Energieausgang / den als fehlerhaft angenommenen Energieausgängen vorliegt. Sinkt die Eingangsspannung erneut, ist mindestens ein weiterer Energieausgang von einem Fehler betroffen und es wird weiter/erneut nach einem fehlerhaften Energieausgang gesucht. Bleibt die Eingangsspannung unverändert oder steigt weiter an, so werden der fehlerhafte Energieausgang bzw. fehlerhaften Energieausgänge wieder eingeschaltet.

In einer weiteren Ausführungsform der Erfindung ist vorgesehen, das im Falle, dass eine Annahme nicht erhärtet werden kann, der betroffene Energieausgang als nicht fehlerhaft in Schritt S500 wieder in Betrieb gesetzt wird. Hierdurch kann erreicht werden, dass Schwankungen auf der Eingangsseite, wie sie z.B. durch Überspannungsereignisse, ins speisende Netz rückwirkende Schaltereignisse, etc. verursacht werden können, zu einem fälschlichen abschalten führen. Damit steigt die Verfügbarkeit der jeweiligen Ausgangsspannungen an.

D.h., auch bei eher schwach ausgelegten Netzteilen kann zuverlässig erkannt werden, ob ein Problem durch eine schwache Auslegung oder durch einen echten Kurzschluss herrührt. Dabei kann insbesondere auf die Strommessung verzichtet werden. D.h. mit den zuvor vorgestellten Verfahren wird ein Kurzschluss sicher erkannt, auch wenn die Nennstromeinstellung eines Geräteschutzschalters zu hoch eingestellt wurde.

## Patentansprüche

1. Energieversorgungseinheit zur Bereitstellung zumindest eines schaltbaren Energieausgangs (Uₒᵤₜ₁, Uₒᵤₜ₂, ..., U_{outN}) aufweisend
• zumindest einen Energieeingang U_{IN},
• zumindest eine Spannungsmesseinrichtung, die die Spannung an dem zumindest einen Energieeingang U_{IN} überwacht,
**dadurch gekennzeichnet, dass**
• wenn die Eingangsspannung unter einen bestimmten Schwellwert Uₜₕᵣₑₛ fällt oder wenn die Änderung der Eingangsspannung U_{IN} pro Zeit über einen bestimmten Schwellwert ΔUₜₕᵣₑₛ/Δt steigt (S150), der Energieausgang / die Energieausgänge (Uₒᵤₜ₁, Uₒᵤₜ₂, ..., U_{outN}) ausgeschaltet wird / werden (S220) und anschließend die Eingangsspannung (U_{IN,t1}) zu einem ersten Zeitpunkt t₁ gemessen wird (S230), wobei nach einer ersten vorbestimmten Zeit (t_{d1}) (S240) die Eingangsspannung U(_{inIN,t2}) zu einem zweiten Zeitpunkt t₂ erneut gemessen (S250) wird, wobei, wenn die Eingangsspannung zum zweiten Zeitpunkt höher ist als die Eingangsspannung zum ersten Zeitpunkt, angenommen wird (S260), dass ein Kurzschluss an zumindest einem Energieausgang vorliegt.

2. Energieversorgungseinheit nach Anspruch 1, wobei nachfolgend zur Annahme (S260), dass ein Kurzschluss an zumindest einem Energieausgang vorliegt, der als fehlerhaft angenommene Energieausgang / die als fehlerhaft angenommenen Energieausgänge (Uₒᵤₜ₁, Uₒᵤₜ₂, ..., U_{outN}) eingeschaltet wird / werden (S340) und anschließend nach einer dritten vorbestimmten Zeit (t_{d3}) (S350) die Eingangsspannung U(IN,t4) zu einem vierten Zeitpunkt t₄ erneut gemessen (S360) wird, wobei, wenn die Eingangsspannung zum vierten Zeitpunkt t₄ niedriger ist als die zuvor zu (t₂ ;oder t₃) gemessene Eingangsspannung, erhärtet angenommen wird (S370), dass ein Kurzschluss an zumindest dem als fehlerhaft angenommene Energieausgang / den als fehlerhaft angenommenen Energieausgängen vorliegt.

3. Energieversorgungseinheit nach Anspruch 2, wobei nachfolgend zur erhärteten Annahme (S370), dass ein Kurzschluss an zumindest dem als fehlerhaft angenommene Energieausgang / den als fehlerhaft angenommenen Energieausgängen vorliegt, der als fehlerhaft angenommene Energieausgang / die als fehlerhaft angenommenen Energieausgängen ausgeschaltet wird / werden (S400), und anschließend nach einer vierten vorbestimmten Zeit t_{d4} (S410) die Eingangsspannung U_{IN,t5} zu einem fünften Zeitpunkt t₅ erneut gemessen (S420) wird, wobei, wenn die Eingangsspannung zum fünften Zeitpunkt höher ist als die zum vierten Zeitpunkt t₄ gemessene Eingangsspannung, entschieden wird (S430), dass ein Kurzschluss an zumindest dem als fehlerhaft angenommene Energieausgang / den als fehlerhaft angenommenen Energieausgängen vorliegt.

4. Energieversorgungseinheit nach Anspruch 3, wobei ein als fehlerhaft erkannter Energieausgang signalisiert wird (S450).

5. Energieversorgungseinheit nach einem der vorhergehenden Ansprüche, wobei die Energieversorgungseinheit eine Mehrzahl von Energieausgängen zur Verfügung stellt, wobei nachfolgend zur Erkennung, dass die Eingangsspannung unter den bestimmten Schwellwert Uₜₕᵣₑₛ fällt oder wenn die Änderung der Eingangsspannung U_{IN} pro Zeit über den bestimmten Schwellwert ΔUₜₕᵣₑₛ/Δt steigt (S150), ein mutmaßlich fehlerhafter Energieausgang zumindest an Hand der jeweiligen Ausgangsspannung bestimmt wird (S200).

6. Energieversorgungseinheit nach einem der vorhergehenden Ansprüche, wobei die Energieversorgungseinheit eine Mehrzahl von Energieausgängen zur Verfügung stellt, wobei nachfolgend zur Annahme (S260), dass ein Kurzschluss an zumindest einem Energieausgang vorliegt, der als fehlerfrei angenommen Energieausgang / die als fehlerfrei angenommenen Energieausgänge eingeschaltet werden (S300) und anschließend nach einer zweiten vorbestimmten Zeit t_{d2} (S310) die Eingangsspannung U(_{in,t3}) zu einem dritten Zeitpunkt t₃ erneut gemessen (S320) wird, wobei, wenn die Eingangsspannung zum dritten Zeitpunkt höher ist als die zum zweiten Zeitpunkt t₂ gemessene Eingangsspannung U_{IN,t2}, angenommen wird (S330), dass ein Kurzschluss an zumindest dem als fehlerhaft angenommene Energieausgang / den als fehlerhaft angenommenen Energieausgängen vorliegt.

7. Energieversorgungseinheit nach einem der vorhergehenden Ansprüche, wobei im Falle, dass eine Annahme nicht erhärtet werden kann, der betroffene Energieausgang als nicht fehlerhaft wieder in Betrieb gesetzt wird (S500).

## Claims

1. Power supply unit for the provision of at least one switchable power output (Uₒᵤₜ₁, Uₒᵤₜ₂, .... U_{outN}), having
• at least one power input U_{IN},
• at least one voltage measuring device that monitors the voltage at the at least one power input U_{IN},
**characterized in that**,
• if the input voltage falls below a defined threshold Uₜₕᵣₑₛ or if the change in the input voltage U_{IN} per time rises (S150) above a defined threshold ΔUₜₕᵣₑₛ/Δt , the power output / power outputs is/are switched off (S220) and the input voltage is then measured (S230) at a first point in time t₁, and, after a first predetermined time (t_{d1}) (S240), the input voltage (U_{inIN,t2}) is measured (S250) again at a second point in time t₂, and if the input voltage at the second point in time is greater than the input voltage at the first point in time, it is assumed (S260) that a short circuit is present at at least one power output.

2. Power supply unit as set forth in claim 1, wherein, following the assumption (S260) that a short circuit is present at at least one power output, Power output or power outputs (Uₒᵤₜ₁, Uₒᵤₜ₂, .... U_{outN}) that is/are assumed to be faulty is/are switched on (S360), and, after a third predetermined time (t_{d3}) (S350), the input voltage (U_{IN,t4}) is subsequently measured (S360) again at a fourth point in time t₄, and if the input voltage at the fourth point in time t₄ is lower than the previously (t₂ ;or t₃) measured input voltage, the assumption is confirmed (S370) that a short circuit is present at at least Power output or power outputs that was/were assumed to be faulty.

3. Power supply unit as set forth in claim 2, wherein, following the confirmed assumption (S370) that a short circuit is present at at least Power output or power outputs that is/are assumed to be faulty, Power output or power outputs assumed to be faulty are switched off (S400), and, after a fourth predetermined time t_{d4} (S410), the input voltage UI_{N,t5} is subsequently measured (S420) again at a fifth point in time t₅, and if the input voltage at the fifth point in time is greater than the input voltage measured at the fourth point in time, it is decided (S430) that a short circuit is present at at least Power output or power outputs assumed to be faulty.

4. Power supply unit as set forth in claim 3, wherein a power output is indicated (S450) as having been identified as faulty.

5. Power supply unit according to one of the preceding claims, wherein the power supply unit provides a plurality of power outputs, and, following the detection of the fact that the input voltage has fallen below a defined threshold Uₜₕᵣₑₛ or that the change in the input voltage (U_{IN}) per time has risen (S150) above a defined threshold ΔUₜₕᵣₑₛ/Δt, an assumed faulty power output is identified (S200) at least on the basis of the respective output voltage.

6. Power supply unit according to one of the preceding claims, wherein the power supply unit makes a plurality of power outputs available, and, following the assumption (S260) that a short circuit is present at at least one power output, the power output or power outputs assumed to be faulty are switched on (S300), and, after a second predetermined time t_{d2} (S310), the input voltage (U_{IN,t3}) is subsequently measured (S320) again at a third point in time t₃, and if the input voltage at the third point in time is greater than the input voltage measured at the second point in time t₂, it is assumed (S330) that a short circuit is present at at least Power output or power outputs assumed to be faulty.

7. Power supply unit according to one of the preceding claims, wherein, in the event that an assumption cannot be confirmed, the relevant power output is put back into operation as non-faulty (S500).

## Revendications

1. Ensemble d'approvisionnement énergétique, destiné à mettre à disposition au moins une sortie d'énergie (Uₒᵤₜ₁, Uₒᵤₜ₂, ..., U_{outN}), comportant
• au moins une entrée d'énergie U_{IN},
• au moins un dispositif de mesure de tension, qui supervise la tension sur l'au moins une entrée d'énergie U_{IN}, **caractérisé en ce que**,
• lorsque la tension d'entrée chute en-dessous d'une certaine valeur seuil Uₜₕᵣₑₛ ou lorsque la variation de la tension d'entrée U_{IN} dans le temps grimpe (S150) au-delà d'une certaine valeur seuil ΔUₜₕᵣₑₛ/Δt, la sortie d'énergie / les entrées d'énergie (Uₒᵤₜ₁, Uₒᵤₜ₂, ... , U_{outN}) est / sont désactivées (S220) et ensuite, la tension d'entrée (U_{IN,t1}) est mesurée (S230) à un premier moment t₁, après un premier temps déterminé (t_{d1}) (S240), la tension d'entrée U(_{inIN,t2}) étant remesurée (S250) à un deuxième moment t₂, si au deuxième moment, la tension d'entrée est plus élevée que la tension d'entrée au premier moment, la présence d'un court-circuit sur au moins une sortie d'énergie étant supposée (S260).

2. Ensemble d'approvisionnement énergétique selon la revendication 1, suite à la supposition (S260) de la présence d'un court-circuit sur au moins une sortie d'énergie, la sortie d'énergie supposée défectueuse / les entrées d'énergie supposées défectueuses (Uₐₒᵤₜ₁, Uₒᵤₜ₂, ... , U_{outN}) étant activée / activées (S340) et ensuite, après un troisième temps prédéfini (t_{d3}) (S350), la tension d'entrée U(_{IN,14}) étant remesurée à un quatrième moment t₄ (S360), si au quatrième moment t₄ la tension d'entrée est inférieure à la tension d'entrée mesurée précédemment à (t₂ ; ou t₃), la présence d'un court-circuit sur au moins la sortie d'énergie supposée défectueuse / les entrées d'énergie supposées défectueuses étant supposée(s) de manière confortée (S370).

3. Ensemble d'approvisionnement énergétique selon la revendication 2, suite à la supposition confortée (S370) de la présence d'un court-circuit sur au moins la sortie d'énergie supposée défectueuse / les entrées d'énergie supposées défectueuses, la sortie d'énergie supposée défectueuse / les entrées d'énergie supposées défectueuses étant désactivée / désactivées (S400), et par la suite, après un quatrième temps prédéfini t_{d4} (S410), la tension d'entrée U_{IN,15} étant remesurée à un cinquième moment t₅ (S420), si au cinquième moment, la tension d'entrée est supérieure à la tension d'entrée mesurée au quatrième moment t₄, la présence d'un court-circuit sur au moins la sortie d'énergie supposée défectueuse / les entrées d'énergie supposées défectueuses étant décidée (S430).

4. Ensemble d'approvisionnement énergétique selon la revendication 3, une sortie d'énergie reconnue défectueuse étant signalée (S450).

5. Ensemble d'approvisionnement énergétique selon l'une quelconque des revendications précédentes, l'ensemble d'approvisionnement énergétique mettant à disposition une pluralité d'entrées d'énergie, par la suite, pour reconnaître que la tension d'entrée chute en-dessous de la valeur seuil Uₜₕᵣₑₛ déterminée ou si la variation de la tension d'entrée U_{IN} dans le temps grimpe (S150) au-delà de la valeur seuil déterminée ΔUₜₕᵣₑₛ/Δt, une sortie d'énergie présumée défectueuse étant déterminée au moins à l'aide de la tension de sortie (S200) respective.

6. Ensemble d'approvisionnement énergétique selon l'une quelconque des revendications précédentes, l'ensemble d'approvisionnement énergétique mettant à disposition une pluralité d'entrées d'énergie, par la suite, pour supposer (S260) la présence d'un court-circuit sur au moins une sortie d'énergie, la sortie d'énergie supposée irréprochable / les entrées d'énergie supposées irréprochables étant activées (S300) et par la suite, après un deuxième temps prédéterminé t_{d2} (S310), la tension d'entrée U(_{in,t3}) étant remesurée (S320) à un troisième moment t₃, si au troisième moment, la tension d'entrée est supérieure à la tension d'entrée U_{IN,12} mesurée au deuxième moment t₂, la présence d'un court-circuit sur au moins la sortie d'énergie supposée défectueuse / les entrées d'énergie supposées défectueuses étant supposée (S330).

7. Ensemble d'approvisionnement énergétique selon l'une quelconque des revendications précédentes, dans le cas où une supposition ne peut pas être confortée, la sortie d'énergie concernée étant remise en service (S500), comme étant non défectueuse.
